# EUROPEAN PATENT SPECIFICATION

(11) **EP 3 405 979 B1**
(45) Date of publication and mention of the grant of the patent: **11.10.2023**
(21) Application number: 17702170.6
(22) Date of filing: 13.01.2017
(51) Int. Cl.: H01L 29/78, H01L 29/778, H01L 29/423, H01L 29/06, H01L 21/336, H01L 29/20, H01L 29/417, H01L 29/80, H01L 29/10

(54) **SEMICONDUCTOR DEVICE, ELECTRONIC PART, ELECTRONIC APPARATUS, AND METHOD FOR FABRICATING SEMICONDUCTOR DEVICE**
HALBLEITERBAUELEMENT, ELEKTRONISCHES TEIL, ELEKTRONISCHE VORRICHTUNG UND VERFAHREN ZUR HERSTELLUNG EINES HALBLEITERBAUELEMENTS
DISPOSITIF À SEMICONDUCTEUR, COMPOSANT ÉLECTRONIQUE, APPAREIL ÉLECTRONIQUE, ET PROCÉDÉ DE FABRICATION D'UN DISPOSITIF À SEMICONDUCTEUR

(30) Priority: 21.01.2016 JP 2016009797
(43) Date of publication of application: 28.11.2018
(73) Proprietor: Sony Group Corporation, Tokyo 108-0075 (JP)
(72) Inventor: TAKEUCHI, Katsuhiko, Tokyo 108-0075 (JP); KANEMATSU, Shigeru, Tokyo 108-0075 (JP); YANAGITA, Masashi, Tokyo 108-0075 (JP)
(74) Representative: MFG Patentanwälte Meyer-Wildhagen Meggle-Freund Gerhard PartG mbB
(86) International application number: PCT/JP2017/001014
(87) International publication number: WO 2017/126428

(56) References cited:
- JP-A- H0 715 018
- JP-A- 2008 218 846
- JP-A- 2009 170 746
- US-A1- 2001 013 604
- US-A1- 2010 006 894
- US-A1- 2013 214 348

## Description

### CROSS REFERENCE TO RELATED APPLICATIONS

### Technical Field

The present disclosure relates to semiconductor devices, electronic parts, electronic apparatuses, and methods for fabricating a semiconductor device.

### Background Art

In recent years, as a semiconductor device employing compound semiconductors, a high electron mobility transistor (HEMT) has attracted attention.

The high electron mobility transistor is a field effect transistor in which a two-dimensional electron gas layer formed by a heterojunction of compound semiconductors is used as a channel. The two-dimensional electron gas layer has a high electron mobility and a high sheet electron density. Therefore, the high electron mobility transistor is a semiconductor device which can perform a low-resistance, high-speed, and high-breakdown-voltage operation.

For example, a high electron mobility transistor has a structure in which a barrier layer is provided on a channel layer, and a source electrode and a drain electrode are provided on the barrier layer. In such a high electron mobility transistor, the barrier layer having a wide band gap serves as a potential barrier, and therefore, the contact resistances between the source and drain electrodes, and the two-dimensional electron gas layer, which is a channel, are high.

Therefore, in order reduce the contact resistances between the source and drain electrodes and the two-dimensional electron gas layer, a technique of alloying the source and drain electrodes and the barrier layer by high-temperature annealing has been proposed. Also, as disclosed in Patent Literature 1 below, a technique for decreasing the contact resistances by selectively regrowing a high-concentration layer doped with impurities at a high concentration in regions which are in contact with the source electrode and the drain electrode, has been proposed.

### Citation List

### Patent Literature

PTL 1: JP 2011-159795A

### Summary

### Technical Problem

However, in the technique disclosed in Patent Literature 1, there is a limit on the decrease of the resistance of the high electron mobility transistor during operation (also referred to as an "on-resistance"). This is because the on-resistance of the field effect transistor is determined by the sum of the contact resistances between the source and drain electrodes and the channel and the channel resistance depending on the distance between the source electrode and the drain electrode, and in the technique disclosed in Patent Literature 1, it is difficult to reduce the distance between the source electrode and the drain electrode.

Moreover, Patent application JP 2008 218846 (A) describes a nitride semiconductor element capable of improving a breakdown voltage between a gate and a drain. Furthermore, Japanese patent application JPH0715018 describes a HEMT with a substrate; a first contact layer on the substrate; a channel layer on the first contact layer, the channel layer including a two-dimensional electron gas layer on side-wall surfaces of the channel layer in a direction perpendicular to the substrate; a second contact layer on the channel layer; a barrier layer on the first contact layer, and on the side walls of the channel layer; a gate electrode on at least one side surface of the barrier layer; a first electrode on the first contact layer; a second electrode on the second contact layer, wherein the first contact layer and the second contact layer are of a first conductivity type.

### Solution to Problem

According to a first aspect, the invention provides a semiconductor device in accordance with independent claim 1. According to a second aspect, the invention provides an electronic part in accordance with dependent claim 8. According to a third aspect, the invention provides an electronic apparatus in accordance with dependent claim 9. According to a fourth aspect, the invention provides a method for fabricating an electronic device in accordance with independent claim 10.

According to an embodiment of the present disclosure, the distance between the source electrode and the drain electrode can be reduced without using state-of-the-art fabrication equipment.

### Advantageous Effects of Invention

As described above, according to an embodiment of the present disclosure, the on-resistance of a semiconductor device can be further reduced.

Note that the effects described above are not necessarily limitative. With or in the place of the above effects, there may be achieved any one of the effects described in this specification or other effects that may be grasped from this specification.

### Brief Description of Drawings

The examples of Figs 1 to 10 and 12 to 17 are only presented as examples not falling under the scope of the appended claims, useful for the understanding of the invention.
[fig.1]FIG. 1 is a cross-sectional view showing a multilayer structure of a semiconductor device according to a first embodiment of the present disclosure.
[fig.2]FIG. 2 is a plan view showing a planar structure of a semiconductor device according to an embodiment.
[fig.3]FIG. 3 is a cross-sectional view showing a process of fabricating the semiconductor device, shown in FIG. 1.
[fig.4]FIG. 4 is a cross-sectional view showing a process of fabricating the semiconductor device shown in FIG. 1.
[fig.5]FIG. 5 is a cross-sectional view showing a process of fabricating the semiconductor device shown in FIG. 1.
[fig.6]FIG. 6 is a cross-sectional view showing a process of fabricating the semiconductor device shown in FIG. 1.
[fig. 7]FIG. 7 is a cross-sectional view showing a process of fabricating the semiconductor device shown in FIG. 1.
[fig.8]FIG. 8 is a cross-sectional view showing a process of fabricating the semiconductor device shown in FIG. 1.
[fig.9]FIG. 9 is a cross-sectional view showing a process of fabricating the semiconductor device shown in FIG. 1.
[fig.10]FIG. 10 is a cross-sectional view showing a multilayer structure of a semiconductor device according to a second embodiment of the present disclosure.
[fig. 11]FIG. 11 is a cross-sectional view showing a multilayer structure of a semiconductor device according to a third embodiment, which falls within the scope of the claimed invention.
[fig.12]FIG. 12 is a cross-sectional view showing a multilayer structure of a semiconductor device according to a fourth embodiment of the present disclosure.
[fig. 13]FIG. 13 is a cross-sectional view showing a multilayer structure of a semiconductor device according to a fifth embodiment of the present disclosure.
[fig. 14]FIG. 14 is a cross-sectional view showing a first structure example of a semiconductor device according to the fifth embodiment of the present disclosure.
[fig. 15]FIG. 15 is a cross-sectional view showing a second structure example of a semiconductor device according to the fifth embodiment of the present disclosure.
[fig. 16]FIG. 16 is a cross-sectional view showing a third structure example of a semiconductor device according to the fifth embodiment of the present disclosure.
[fig. 17]FIG. 17 is a cross-sectional view showing a multilayer structure of a semiconductor device according to a comparative example.

### Description of Embodiments

Hereinafter, (an) embodiment(s) of the present disclosure will be described in detail with reference to the appended drawings. In this specification and the appended drawings, structural elements that have substantially the same function and structure are denoted with the same reference numerals, and repeated explanation of these structural elements is omitted.

Note that description will be provided in the following order.
0. Technical background of the present disclosure
1. First embodiment
1.1. Structure of semiconductor device
1.2. Method for fabricating semiconductor device
2. Second embodiment
3. Third embodiment
4. Fourth embodiment
5. Fifth embodiment
6. Sixth embodiment
6.1. First structure example
6.2. Second structure example
6.3. Third structure example
7. Conclusion

### <<0. Technical background of the present disclosure>>

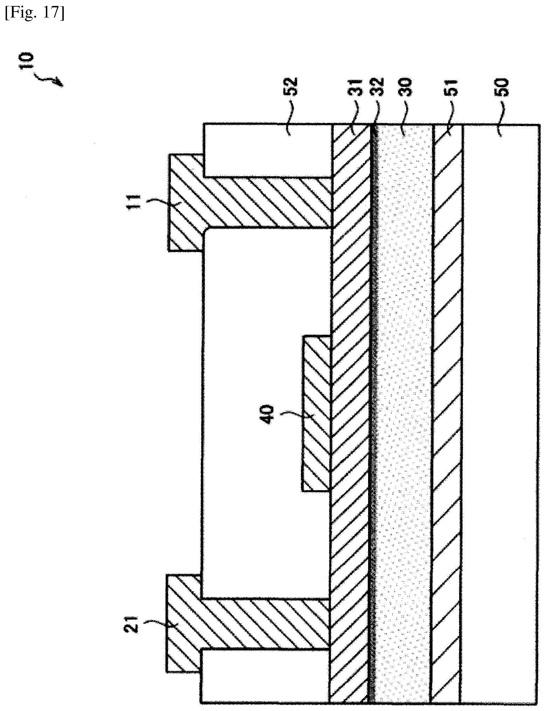

Firstly, the technical background of the present disclosure will be described with reference to FIG. 17. FIG. 17 is a cross-sectional view showing a multilayer structure of a compound semiconductor transistor which is a semiconductor device according to a comparative example.

As shown in FIG. 17, the compound semiconductor transistor 10 according to the comparative example includes a buffer layer 51 provided on a substrate 50, a channel layer 30 provided on the buffer layer 51, a barrier layer 31 provided on the channel layer 30, a gate electrode 40, source electrode 21, and drain electrode 11 provided on the barrier layer 31, and an insulating layer 52 which insulates the gate electrode 40, the source electrode 21, and the drain electrode 11 from each other. Also, a two-dimensional electron gas layer 32 which is a channel is formed in the vicinity of an interface of the channel layer 30 which is in contact with the barrier layer 31.

The substrate 50 is formed of, for example, silicon (Si), silicon carbide (SiC), gallium nitride (GaN), sapphire, or the like.

The buffer layer 51 is formed of a compound semiconductor material, and is for epitaxially growing the channel layer 30 and the barrier layer 31 on the substrate 50. Specifically, the buffer layer 51 is formed of a compound semiconductor material the grating constant of which is appropriately controlled, and can be used to control the crystal orientation and crystalline state of the channel layer 30 provided on the buffer layer 51. As a result, even when the substrate 50 and the channel layer 30 have significantly different grating constants, the channel layer 30 can be epitaxially grown.

The channel layer 30 is formed of a compound semiconductor material, and the barrier layer 31 is formed of a compound semiconductor material different from that of the channel layer 30. The different compound semiconductor materials are joined together at an interface between the channel layer 30 and the barrier layer 31, so that an electron layer called the two-dimensional electron gas layer 32 is formed.

Note that the channel layer 30 in which the two-dimensional electron gas layer 32 is formed may be formed of an i-type (i.e., undoped) compound semiconductor. When the channel layer 30 is of the i-type, impurity scattering is reduced, and therefore, the two-dimensional electron gas layer 32 can be used as a high-mobility channel. Also, the barrier layer 31 may be formed of either an i-type or n-type compound semiconductor if the barrier layer 31 allows formation of the two-dimensional electron gas layer 32. The barrier layer 31 may be formed of an n-type compound semiconductor in order to increase the electron density of the two-dimensional electron gas layer 32 which is a channel.

A compound semiconductor transistor which includes such a two-dimensional electron gas layer (32) as a channel is also called a "high electron mobility transistor (HEMT). "

Examples of the combination of compound semiconductor materials which form such a heterojunction include GaAs and AlGaAs, GaN and AlGaN, GaAs and InGaP, GaN and AlInN, and the like.

The gate electrode 40 is formed of a metal such as nickel (Ni), titanium (Ti), gold (Au), or the like. The gate electrode 40 and the barrier layer 31 form a Schottky junction, which forms, in the barrier layer 31, a depletion layer extending from the gate electrode 40. Meanwhile, in the barrier layer 31, the two-dimensional electron gas layer 32 formed in the channel layer 30 forms a depletion layer extending from the channel layer 30.

In the compound semiconductor transistor 10, the electron concentration of the two-dimensional electron gas layer 32 can be controlled by controlling a voltage applied to the gate electrode 40 so that the compound semiconductor transistor 10 functions as an field effect transistor in which a two-dimensional electron gas layer is a channel.

The source electrode 21 and the drain electrode 11 are formed of a metal such as titanium (Ti), aluminum (Al), or the like. Also, the source electrode 21 and the drain electrode 11 are formed to provide an ohmic contact with the channel layer 30.

Here, in the compound semiconductor transistor 10, the resistance during operation (also called an "on-resistance") is high. This is because the barrier layer 31, which is a high potential barrier, is interposed between each of the source electrode 21 and the drain electrode 11, and the two-dimensional electron gas layer 32 which is a channel, so that the contact resistance is high.

Therefore, in order to reduce the contact resistance, for example, a technique of reducing the potential barrier by replacing a portion of the barrier layer 31 with a layer doped with impurities at a high concentration, has been proposed. Also, in order to reduce the contact resistance, a technique of alloying a metal of which the source electrode 21 and the drain electrode 11 are formed, and the barrier layer 31, by high-temperature annealing, has been proposed.

However, when the contact resistance is only reduced, there is a limit on the decrease of the on-resistance of the compound semiconductor transistor 10. This is because the on-resistance of the compound semiconductor transistor 10 includes a channel resistance depending on the distance between the source electrode 21 and the drain electrode 11.

The channel resistance may be reduced by, for example, employing a fabrication process capable of further miniaturization and thereby reducing the distance between the source electrode 21 and the drain electrode 11. However, when a fabrication process capable of further miniaturization is employed, the fabrication cost increases significantly. Therefore, it has been difficult to further reduce the on-resistance of the compound semiconductor transistor 10 while inhibiting the increase of the fabrication cost.

The present inventors have extensively studied the above circumstances to find the technology according to the present disclosure. A semiconductor device according to one embodiment of the present disclosure has a novel and improved structure in which the distance between the source electrode and the drain electrode can be reduced so that the on-resistance is further reduced.

The above semiconductor device according to one embodiment of the present disclosure will now be described in detail.

### «1. First embodiment»

### <1.1. Structure of semiconductor device>

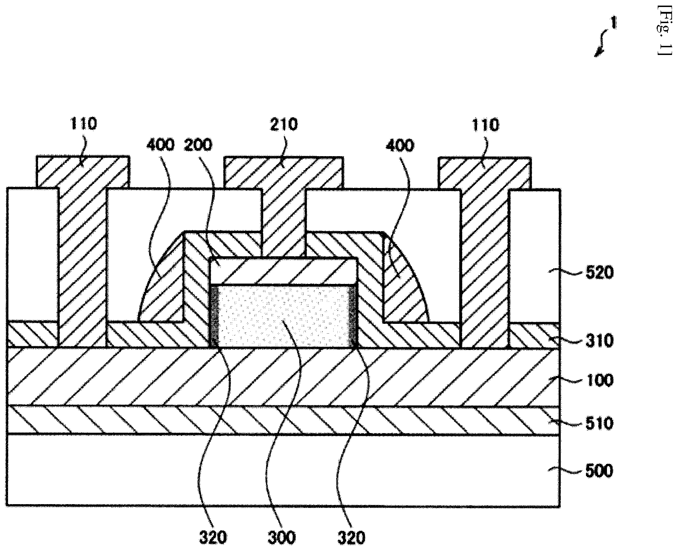

Firstly, a multilayer structure of a semiconductor device according to a first embodiment of the present disclosure will be described with reference to FIG. 1. FIG. 1 is a cross-sectional view showing the multilayer structure of the semiconductor device 1 according to this embodiment.

As shown in FIG. 1, the semiconductor device 1 according to this embodiment includes a substrate 500, a buffer layer 510, a first contact layer 100, a channel layer (or region) 300, a second contact layer 200, a barrier layer 310, a gate electrode 400, a first electrode 110, a second electrode 210, and an insulating layer 520.

Note that the semiconductor device 1 according to this embodiment is a high electron mobility transistor. A two-dimensional electron gas layer 320 which is a channel is formed in the vicinity of an interface of the channel layer 300 which is in contact with the barrier layer 310, substantially perpendicularly to the substrate 500.

The substrate 500 is formed of a compound semiconductor material. Specifically, the substrate 500 is formed of a group III-V compound semiconductor material. For example, the substrate 500 may be a semi-insulating monocrystalline gallium nitride (GaN) substrate. Also, when the buffer layer 510 described below is provided, the substrate 500 may be formed of a material which has a grating constant different from that of the first contact layer 100 provided on the substrate 500. In such a case, the substrate 500 may, for example, be a silicon (Si) substrate, silicon carbide (SiC) substrate, sapphire substrate, or the like.

The buffer layer 510 is provided on the substrate 500, and is formed of an epitaxially grown compound semiconductor material. Specifically, the buffer layer 510 is formed of a compound semiconductor material having an appropriate grating constant based on the grating constants of the substrate 500 and the first contact layer 100. When the substrate 500 and the first contact layer 100 have different grating constants, the grating constant of the buffer layer 510 can be controlled so that the first contact layer 100 can have a good crystalline state and the warpage of the semiconductor device 1 is controlled. For example, when the substrate 500 is a Si substrate, and the first contact layer 100 is formed of GaN, the buffer layer 510 can be formed of AlN, AlGaN, GaN, or the like.

The first contact layer 100 is provided on the buffer layer 510, and is formed of a compound semiconductor material doped with an impurity at a high concentration. Specifically, the first contact layer 100 may be formed of the same compound semiconductor material as that of the channel layer 300 described below that is doped with an n-type impurity at a high concentration. The first contact layer 100, the resistance of which is reduced by the high-concentration doping, can reduce the contact resistance between the first contact layer 100 and the first electrode 110. For example, when the channel layer 300 is formed of GaN, the first contact layer 100 may be formed of epitaxially grown GaN which is doped with silicon (Si) or germanium (Ge). Also, the concentration of the impurity for the doping may be 1.0 × 10¹⁸/cm³ or more.

The channel layer 300 is provided in an island shape on a partial region of the first contact layer 100, and is formed of a compound semiconductor material in which carriers are accumulated due to a heterojunction between the channel layer 300 and the barrier layer 310. Also, the two-dimensional electron gas layer 320 is formed on a side surface of the channel layer 300, in a direction substantially perpendicular to the substrate 500. Specifically, the channel layer 300 may be formed of a compound semiconductor material which is not doped with an impurity, i.e., an i-type (i.e., undoped) compound semiconductor material. In such a case, in the channel layer 300, carrier scattering caused by impurities is inhibited, and therefore, carrier mobility can be improved in the two-dimensional electron gas layer 320. For example, the channel layer 300 may be formed of epitaxially grown GaN.

Also, the two-dimensional electron gas layer 320 is epitaxially grown and formed on the side surface of the channel layer 300 so that the C-axis direction of the crystal is substantially perpendicular to the side surface of the channel layer 300. For example, in the case of GaN, a two-dimensional electron gas layer is formed on the polar c-plane (0001) of the crystal. Therefore, the crystal orientation of the channel layer 300 may be appropriately controlled so that the two-dimensional electron gas layer 320 is formed on the side surface of the channel layer 300. Note that, as long as the two-dimensional electron gas layer 320 can be formed on the side surface of the channel layer 300, the C-axis of the crystal orientation of the channel layer 300 may not be perpendicular to the side surface, and may be inclined in any direction by up to about 55°. Note that when the angle of the inclination is large, it is difficult to form the two-dimensional electron gas layer 320 on the side surface, and therefore, the inclination angle of the C-axis of the crystal may be within 10° or less in any direction with respect to the normal direction of the side surface.

The second contact layer 200 is provided on the channel layer 300, and is formed of a compound semiconductor material doped with an impurity at a high concentration. Specifically, the second contact layer 200 may be formed of the same compound semiconductor material as that of the channel layer 300 that is doped with an n-type impurity at a high concentration. The second contact layer 200, the resistance of which is reduced by the high-concentration doping, can reduce the contact resistance between the second contact layer 200 and the second electrode 210. For example, when the channel layer 300 is formed of GaN, the second contact layer 200 may be formed of epitaxially grown GaN which is doped with silicon (Si) or germanium (Ge). Also, the concentration of the impurity for the doping may be 1.0 × 10¹⁸/cm³ or more.

The barrier layer 310 is provided on the first contact layer 100 and the second contact layer 200, and is formed of a compound semiconductor material which causes carriers to be accumulated in the channel layer 300 due to a heterojunction between the barrier layer 310 and the channel layer 300. Specifically, the barrier layer 310 is formed of a compound semiconductor material different from that of the channel layer 300. Also, the barrier layer 310 may be formed of a compound semiconductor material which is not doped with an impurity, i.e., an i-type (i.e., undoped) compound semiconductor material. In such a case, the barrier layer 310 can inhibit carrier scattering caused by impurities in the channel layer 300, and therefore, the carrier mobility of the two-dimensional electron gas layer 320 can be improved. For example, when the channel layer 300 is formed of GaN, the barrier layer 310 may be formed of epitaxially grown Al_{1-x-y}GaₓIn_{y}N (0 ≦ x < 1,0 ≦ y < 1, excluding x = y = 0).

Note that, as long as the two-dimensional electron gas layer 320 is formed by a heterojunction, the channel layer 300 and the barrier layer 310 may be formed of respective compound semiconductor materials a combination of which is different from that described above. For example, the channel layer 300 and the barrier layer 310 may be formed of GaAs and AlGaAs, GaAs and InGaP, or GaN and AlInN, respectively.

The gate electrode 400 is provided on the side surface of the channel layer 300 with the barrier layer 310 being interposed therebetween. Also, the gate electrode 400 is formed of a metal which forms a Schottky junction between the gate electrode 400 and the barrier layer 310. For example, the gate electrode 400 may be formed by successively forming a layer of nickel (Ni) and a layer of gold (Au) on top of each other, where the nickel layer is closer to the barrier layer 310. As a result, the concentration of the two-dimensional electron gas layer 320 can be controlled by controlling a voltage applied to the gate electrode 400.

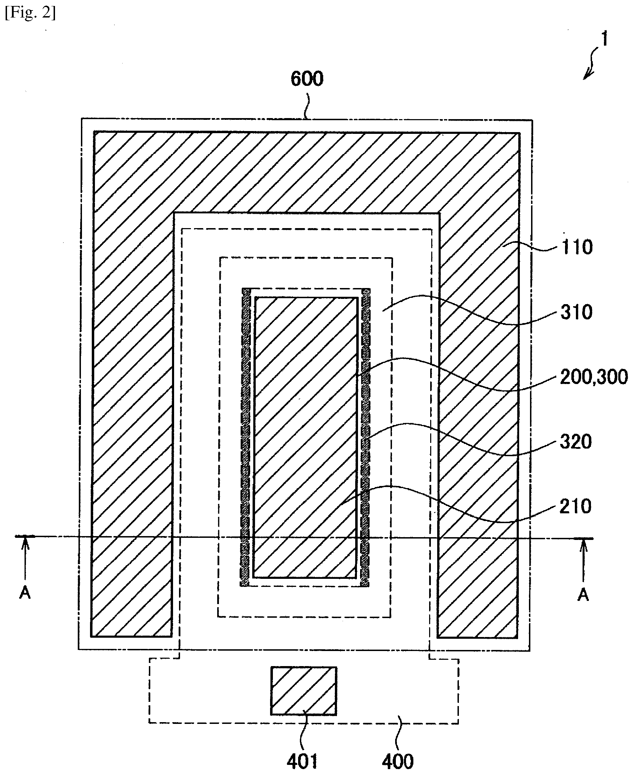

Note that, as shown in FIG. 2, the gate electrode 400 is coupled to a control electrode 401 provided on the insulating layer 520, in a region outside a device region 600 where the semiconductor device 1 is provided. A voltage applied to the gate electrode 400 is controlled through the control electrode 401.

The insulating layer 520 is formed of an insulating material, and is provided to cover the entire surfaces of the barrier layer 310 and the gate electrode 400. The insulating layer 520 insulates the barrier layer 310 and the gate electrode 400 from other electrodes, interconnects, and the like, and protects the barrier layer 310 and the gate electrode 400 from impurities such as ions and the like. The insulating layer 520 may be a monolayer film of, for example, SiN, Si₃N₄, SiO, SiO₂, Al₂O₃, or the like, or a multilayer film thereof.

The first electrode 110 is configured to be coupled to the first contact layer 100, while the second electrode 210 is configured to be coupled to the second contact layer 200. For example, the first electrode 110 and the second electrode 210 may be formed by successively forming a layer of titanium (Ti) and a layer of aluminum (Al), or the like, on top of each other, where the titanium layer is closer to the first contact layer 100 and the second contact layer 200. Also, the first electrode 110 may be a source electrode, while the second electrode 210 may be drain electrode, or vice versa, of course.

In the semiconductor device 1 according to this embodiment, the two-dimensional electron gas layer 320 is formed in the channel layer 300 by a heterojunction between the channel layer 300 and the barrier layer 310, substantially perpendicularly to the substrate 500. An upper end of the two-dimensional electron gas layer 320 is coupled to the second electrode 210 with the second contact layer 200 being interposed therebetween, while a lower end of the two-dimensional electron gas layer 320 is coupled to the first electrode 110 with the first contact layer 100 being interposed therebetween. In other words, in the semiconductor device 1, the two-dimensional electron gas layer 320 forms a current path between the first electrode 110 and the second electrode 210.

Also, in the semiconductor device 1, a current flowing between the first electrode 110 and the second electrode 210 can be modulated by the concentration of the two-dimensional electron gas layer 320 being modulated by a Schottky junction formed between the barrier layer 310 and the gate electrode 400. Specifically, when a positive bias is applied to the gate electrode 400, a current flowing between the first electrode 110 and the second electrode 210 is generated by electrons accumulated in the two-dimensional electron gas layer 320. Meanwhile, when a negative bias is applied to the gate electrode 400, the Schottky junction depletes electrons in the two-dimensional electron gas layer 320 of the channel layer 300 facing the gate electrode 400, so that a current does not flow between the first electrode 110 and the second electrode 210. Such an operation allows the semiconductor device 1 to function as a field effect transistor. As also shown in FIG. 1, the gate electrode 400 and the second electrode 210 are between first and second portions of the first electrode 110 (e.g., where the first portion of the first electrode 110 is on a left side of the semiconductor device 1 and the second portion of the first electrode 110 is on a right side of the semiconductor device 1). The barrier layer 310 includes at least one side surface. For example, in FIG. 2, the barrier layer 310 includes a first side surface and a second side surface (e.g., the surfaces adjacent to the two-dimensional electron gas layer 320). The gate electrode 400 includes a first portion on the first side surface of the barrier layer 310 and a second portion on the second side surface of the barrier layer 310 (e.g., where the first portion of the gate electrode 400 is on a left side of the semiconductor device 1 and the second portion of the gate electrode 400 is on a right side of the semiconductor device 1). The second electrode 210 is between the first and second portions of the gate electrode 400. In view of the above, it may be said that the barrier layer 310 is on at least one side surface of the channel layer 300.

Next, a planar structure of the semiconductor device 1 according to this embodiment will be described with reference to FIG. 2. FIG. 2 is a plan view showing the planar structure of the semiconductor device 1 according to this embodiment. Note that a cross-sectional structure of the semiconductor device 1 shown in FIG. 1 corresponds to a cross-sectional multilayer structure taken along a cut line A of FIG. 2.

As shown in FIG. 2, in the semiconductor device 1, the channel layer 300 is provided in an island shape in planar view, while the second contact layer 200 and the second electrode 210 are provided on the channel layer 300. Also, the barrier layer 310, the gate electrode 400, and the first electrode 110 are provided around the channel layer 300. In other words, the channel layer 300 is said to have an island shape because the first electrode 110 is disposed around at least three sides of the channel layer 300 in a plan view, and the gate electrode 400 and the barrier layer 310 surround the channel layer 300 in the plan view. However, example embodiments are not limited thereto. For example, the first electrode 110 may be disposed around all sides of (i.e., surround) the channel layer 300, and the barrier layer 310 and the gate electrode 400 may be disposed around less than all four sides of the channel layer 300 (e.g., three sides). In view of FIG. 2, it may be said that the barrier layer 310 is formed around the channel layer 300 and that the gate electrode 400 is formed around side surfaces of the barrier layer 310.

Also, each component of the semiconductor device 1 is provided in the device region 600. A region outside the device region 600 has a high resistance so that the semiconductor device 1 is electrically separated from other semiconductor devices provided on the substrate 500. The high resistance may be imparted to the region outside the device region 600 by, for example, injecting impurity ions such as boron (B) ions or the like into the first contact layer 100, or by burying an insulating material in an opening formed by removal of the first contact layer 100 using etching or the like. Note that, as described above, the control electrode 401 which is coupled to the gate electrode 400 and is used to control a voltage applied to the gate electrode 400, is provided in the region outside the device region 600.

In such a planar structure of the semiconductor device 1, the two-dimensional electron gas layer 320 can be formed on the side surface of the channel layer 300 (specifically, a surface substantially perpendicular to the C-axis of the crystal), and therefore, the current density can be higher than that of the compound semiconductor transistor 10 shown in FIG. 17.

In the semiconductor device 1 having the above structure, the thickness of the channel layer 300 corresponds to a distance between the source electrode and the drain electrode. The thickness of the channel layer 300 can be controlled on the nanometer scale without using state-of-the-art fabrication equipment, and therefore, in the semiconductor device 1, the distance between the source electrode and the drain electrode can be reduced irrespective of the miniaturization capability of the fabrication process. Therefore, in the semiconductor device 1 according to this embodiment, the reduction of the distance between the source electrode and the drain electrode can reduce the channel resistance, resulting in a reduction in the on-resistance.

Also, in the semiconductor device 1 according to this embodiment, the thickness of the channel layer 300 also corresponds to the gate length. Therefore, the gate length can be similarly reduced irrespective of the miniaturization capability of the fabrication process, whereby the semiconductor device 1 can operate at higher speed. In addition, in the semiconductor device 1 according to this embodiment, the side surface of the channel layer 300 formed in an island shape can be used as a channel to provide a higher current density, and therefore, the semiconductor device can have a size smaller than those of field effect transistors having other structures (e.g., the compound semiconductor transistor 10 shown in FIG. 17).

### <1.2. Method for fabricating semiconductor device>

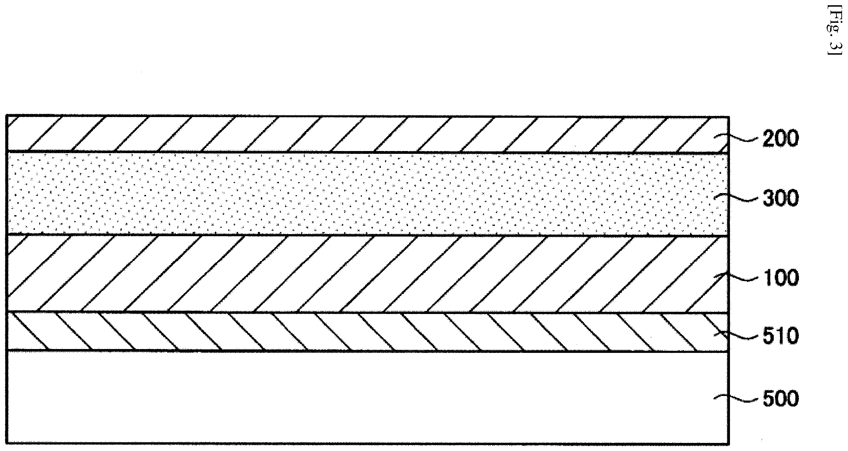

Next, a method for fabricating the semiconductor device 1 according to this embodiment will be described with reference to FIG. 3 to FIG. 9. FIG. 3 to FIG. 9 are cross-sectional views showing a process of fabricating the semiconductor device 1 shown in FIG. 1.

Initially, as shown in FIG. 3, on the substrate 500, the buffer layer 510, the first contact layer 100, the channel layer 300, and the second contact layer 200 are epitaxially grown on top of each other, in that order, by metal organic chemical vapor deposition (MOCVD), molecular beam epitaxy (MBE), or the like.

For example, the substrate 500 may be a silicon (Si) substrate. Also, the buffer layer 510 is formed of, for example, AlN, AlGaN, or GaN, while the first contact layer 100 and the second contact layer 200 may be formed of, for example, n-type GaN doped with silicon (Si). Note that the channel layer 300 may be formed of, for example, undoped GaN so that the C-axis of the crystal faces in a direction substantially perpendicular to the thickness direction of the substrate 500. In order to control the crystal orientation of the channel layer 300, for example, the plane orientation of a surface of the substrate 500 on which the semiconductor device 1 is to be formed may be appropriately controlled.

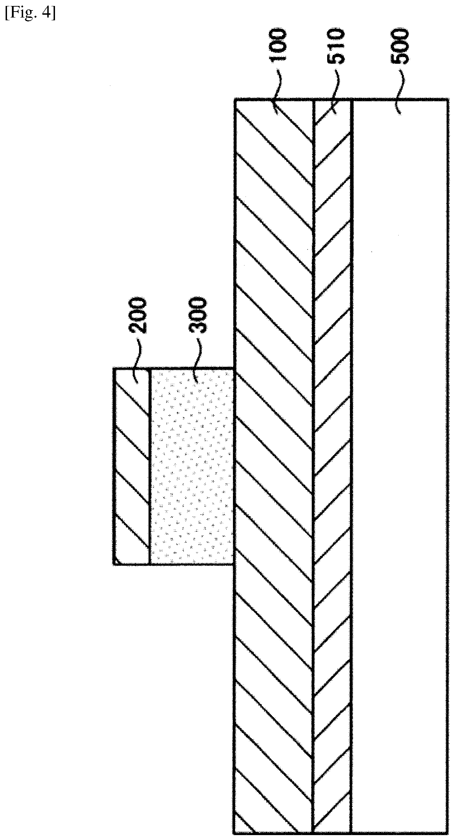

Next, as shown in FIG. 4, patterning is performed on the channel layer 300 and the second contact layer 200 by wet etching or dry etching using a photoresist as a mask. Note that when the first contact layer 100 and the channel layer 300 are formed of substantially the same compound semiconductor, a surface of the first contact layer 100 may be etched during this patterning step, which does not significantly affect the characteristics of the semiconductor device 1.

Here, although not shown, after the patterning has been performed on the channel layer 300 and the second contact layer 200, an isolation step is performed in order to separate semiconductor devices on the substrate 500 from each other. For example, the isolation may be achieved by injecting impurity ions such as boron (B) ions or the like into the first contact layer 100 so that the region outside the device region 600 on which the semiconductor device 1 is formed has a high resistance. Alternatively, the isolation may be achieved by removing the first contact layer 100 in the region outside the device region 600 on which the semiconductor device 1 is formed, using etching or the like, and then burying an insulating material.

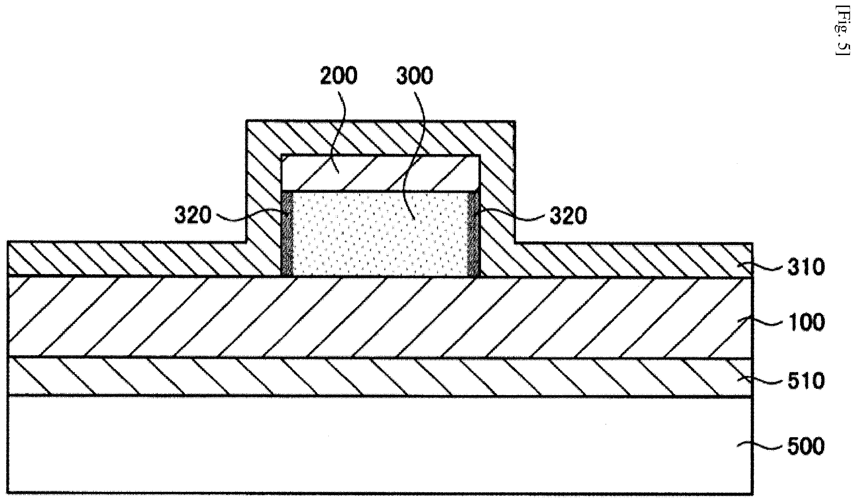

Next, as shown in FIG. 5, the barrier layer 310 is epitaxially grown on the first contact layer 100 and the second contact layer 200 by MOCVD, MBE, or the like. As a result, the two-dimensional electron gas layer 320 is formed in the vicinity of an interface of the channel layer 300 which is in contact with the barrier layer 310. For example, the barrier layer 310 may be formed of AlGaN or AlGaInN.

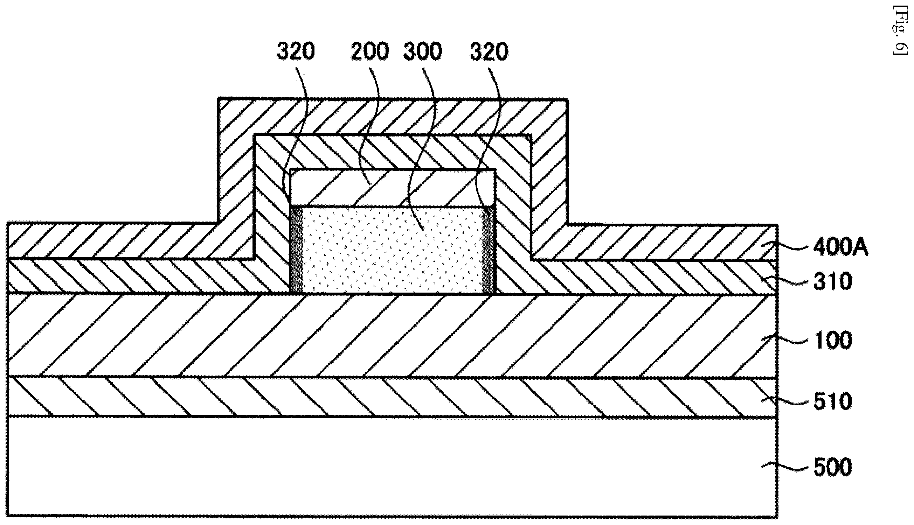

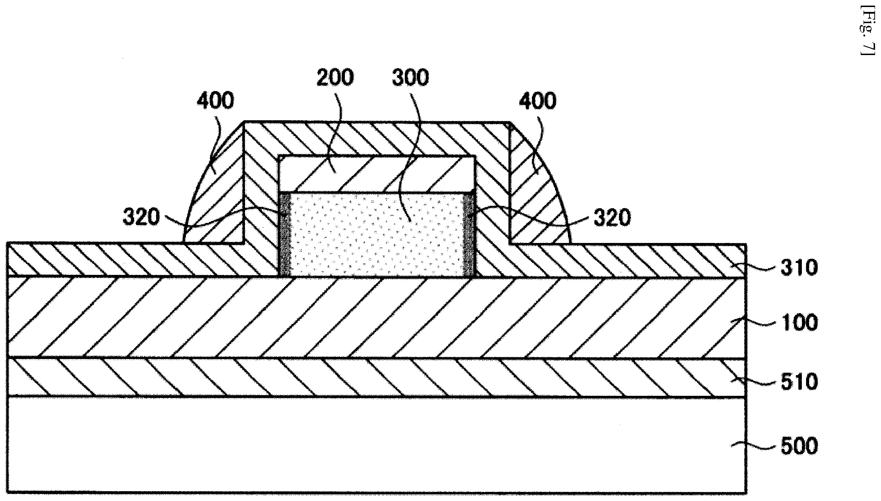

Next, as shown in FIG. 6, a gate electrode material layer 400A is formed on the barrier layer 310 by sputtering or the like. For example, the gate electrode material layer 400A may be formed by successively forming a layer of nickel (Ni) and a layer of gold (Au) on top of each other. Here, as shown in FIG. 7, the entire surface of the gate electrode material layer 400A can be etched using dry etching having perpendicular anisotropy so that the gate electrode 400 is formed only on the side surface of the channel layer 300 protruding on the first contact layer 100.

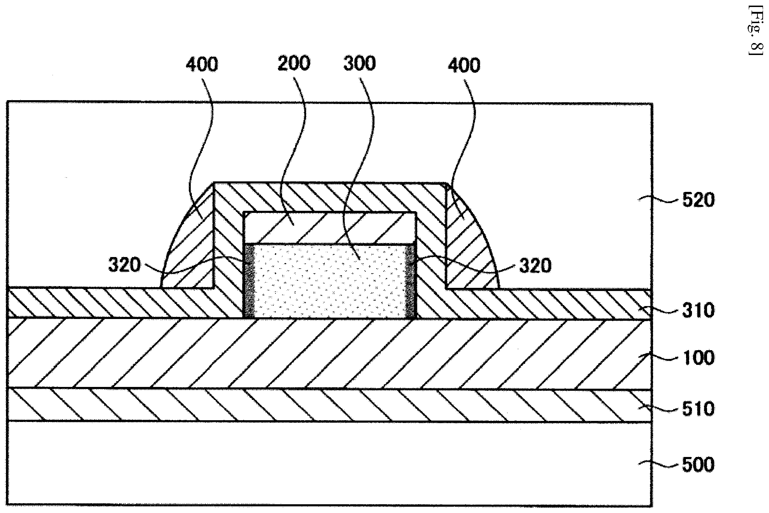

Next, as shown in FIG. 8, the insulating layer 520 is formed on the entire surfaces of the barrier layer 310 and the gate electrode 400 by chemical vapor deposition (CVD) or the like. The insulating layer 520 may be a monolayer film of, for example, SiN, Si₃ N₄, SiO, SiO₂, Al₂O₃, or the like, or a multilayer film thereof.

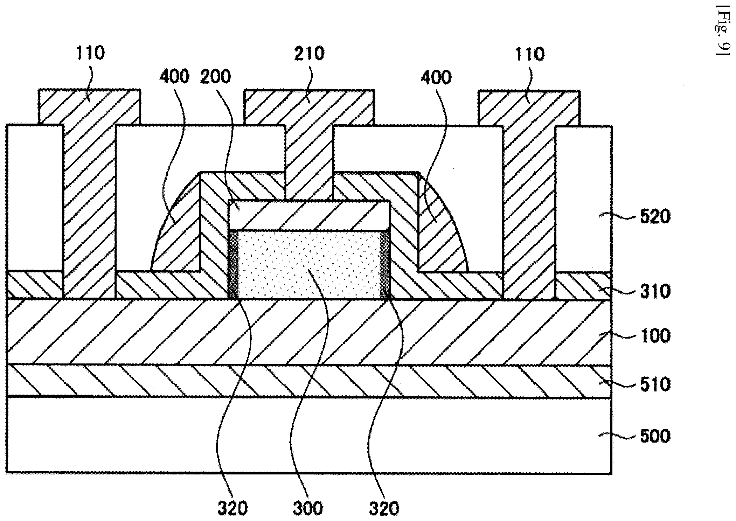

Next, as shown in FIG. 9, openings are formed in partial regions of the barrier layer 310 and the insulating layer 520 by wet etching or dry etching using a photoresist as a mask, and in the openings, the first electrode 110 and the second electrode 210 are formed. As a result, the first electrode 110 and the second electrode 210 can be coupled to the first contact layer 100 and the second contact layer 200, respectively, and therefore, a current path is formed with the two-dimensional electron gas layer 320 serving as a channel. For example, the first electrode 110 and the second electrode 210 may be formed by forming metal layers such as a layer of titanium (Ti) and a layer of aluminum (Al) or the like on top of each other and then performing patterning.

The above fabrication steps can be used to fabricate the semiconductor device 1 according to this embodiment. In the semiconductor device 1 according to this embodiment, the gate electrode 400 can be formed only on the side surface of the channel layer 300 protruding on the first contact layer 100 by so-called self-alignment without using a mask or the like. Therefore, according to the above fabrication method, the semiconductor device 1 according to this embodiment can be easily fabricated without the need of a large additional cost. In view of FIGS. 3-9, it may be said that a method for fabricating a semiconductor device includes forming a first contact layer 100 of a first conductivity type on a substrate; forming a channel layer 300 on the first contact layer; forming a second contact layer 200 of the first conductivity type on the first contact layer 100 and the channel layer 300; etching the channel layer 300 and the second contact layer 200 to expose a portion of the first contact layer 100; forming a barrier layer 310 on the portion of the first contact layer 100 and the etched second contact layer 200; forming a gate electrode 400 on at least one side surface of the barrier layer 310; and forming a first electrode 110 and a second electrode 210 on the first contact layer 100 and the second contact layer 200, respectively. The forming a gate electrode 400 includes forming an electrode material layer on the barrier layer 310, and etching the electrode material layer to form the gate electrode 400. The etching the electrode material layer is an anisotropic etching operation. The forming a first electrode 110 and a second electrode 210 includes forming an insulating layer 520 on the barrier layer 310 and the gate electrode, etching the insulating layer 520 and the barrier layer 310 to form openings that expose the first contact layer 100 and the second contact layer 200, and filling the openings with a conductive material.

### «2. Second embodiment»

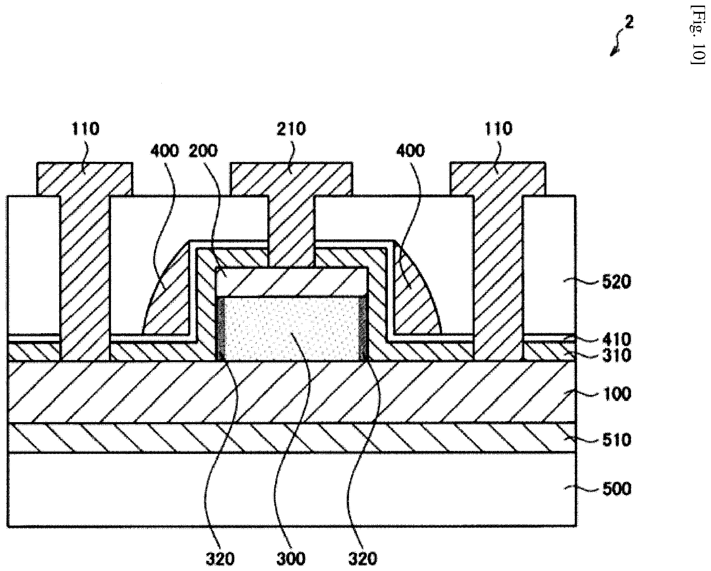

Next, a semiconductor device 2 according to a second embodiment of the present disclosure will be described with reference to FIG. 10. FIG. 10 is a cross-sectional view showing a multilayer structure of the semiconductor device 2 according to this embodiment. Note that components indicated by the same reference signs as those of FIG. 1 are substantially the same as those shown in FIG. 1, and therefore, will not be described herein.

As shown in FIG. 10, the semiconductor device 2 according to this embodiment includes a gate insulating layer 410 which is provided between the barrier layer 310 and the gate electrode 400. In other words, the semiconductor device 2 according to this embodiment has a metal-insulator-semiconductor (MIS) gate structure.

The gate insulating layer 410 is formed of an insulating material. For example, the gate insulating layer 410 may be formed of SiO₂ or Al₂O₃ using atomic layer deposition (ALD). In the semiconductor device 2 according to this embodiment, an MIS gate is formed by the gate insulating layer 410 being provided between the barrier layer 310 and the gate electrode 400.

In the MIS gate, by applying a voltage to the gate electrode 400, the carrier concentration or band state of the barrier layer 310 is modulated. Therefore, in the semiconductor device 2 according to this embodiment, by applying a voltage to the gate electrode 400, the electron concentration of the two-dimensional electron gas layer 320 can be controlled so that a current flowing between the first electrode 110 and the second electrode 210 is modulated.

In the semiconductor device 2 having such an MIS gate, the breakdown resistance of the gate structure is improved, compared to the semiconductor device 1 having a Schottky gate shown in FIG. 1, and therefore, a higher voltage can be applied to the gate electrode 400.

### <<3. Third embodiment, according to the present invention >>

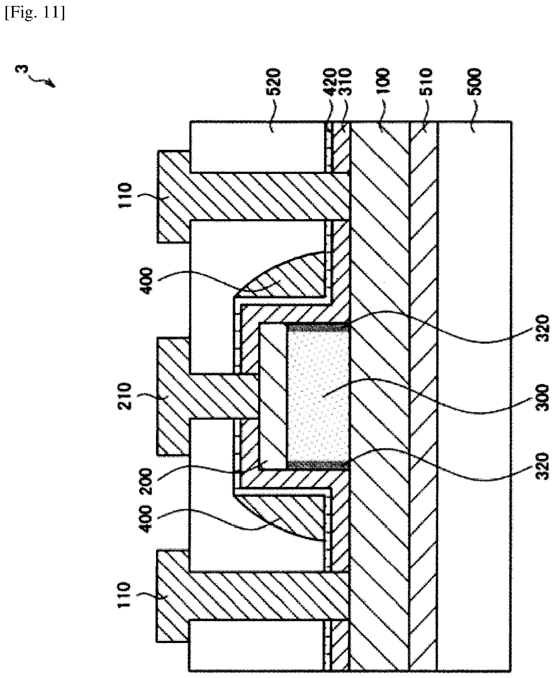

Next, a semiconductor device 3 according to a third embodiment of the present invention will be described with reference to FIG. 11. FIG. 11 is a cross-sectional view showing a multilayer structure of the semiconductor device 3 according to the invention. Note that components indicated by the same reference signs as those of FIG. 1 are substantially the same as those shown in FIG. 1, and therefore, will not be described herein.

As shown in FIG. 11, the semiconductor device 3 according to the invention includes a second conductivity type (e.g., p-type) semiconductor layer 420 which is provided between the barrier layer 310 and the gate electrode 400. In other words, the semiconductor device 3 according to the present invention has a second conductivity type (e.g. p-type) gate.

The semiconductor layer 420 is formed of a second conductivity type (e.g., p-type) semiconductor. For example, the semiconductor layer 420 may be formed by epitaxially growing GaN doped with Mg, which is a p-type impurity, on the barrier layer 310. In the semiconductor device 3 according to the invention, a second conductivity type (p-type) gate is formed by the semiconductor layer 420 being provided between the barrier layer 310 and the gate electrode 400. Also, but not forming part of the present invention, the semiconductor layer 420 may be formed by doping all or a portion of the barrier layer 310 which is in contact with the gate electrode 400 with Mg, which is a p-type impurity.

In the second conductivity type (p-type) gate, by applying a voltage to the gate electrode 400, the carrier concentration or band state of the barrier layer 310 is modulated through the p-n junction. Therefore, in the semiconductor device 3 according to the present invention, by applying a voltage to the gate electrode 400, the electron concentration of the two-dimensional electron gas layer 320 can be controlled so that a current flowing between the first electrode 110 and the second electrode 210 is modulated.

In the semiconductor device 3 having such a second conductivity type (p-type) gate, the threshold voltage can be higher than that of the semiconductor device 1 having a Schottky gate shown in FIG. 1, and therefore, a normally-off operation can be easily achieved.

### «4. Fourth embodiment»

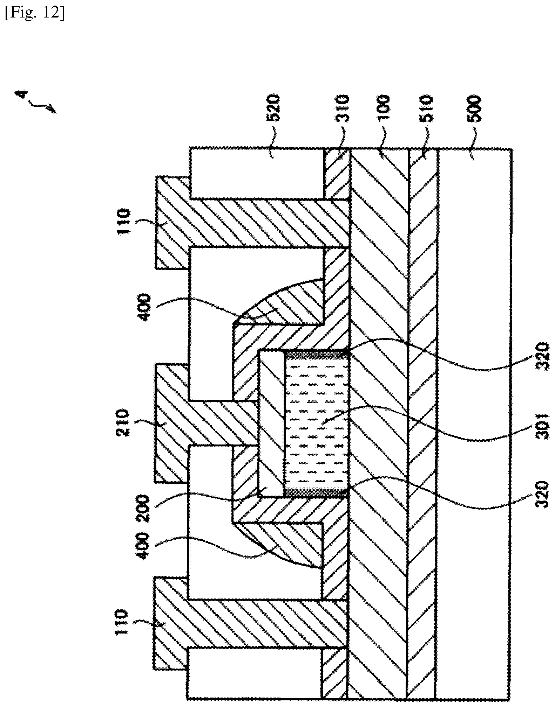

Next, a semiconductor device 4 according to a fourth embodiment of the present disclosure will be described with reference to FIG. 12. FIG. 12 is a cross-sectional view showing a multilayer structure of the semiconductor device 4 according to this embodiment. Note that components indicated by the same reference signs as those of FIG. 1 are substantially the same as those shown in FIG. 1, and therefore, will not be described herein.

As shown in FIG. 12, in the semiconductor device 4 according to this embodiment, a channel layer 301 is formed of a second conductivity type (e.g., p-type) compound semiconductor material. For example, the channel layer 301 may be formed by epitaxially growing GaN doped with Mg, which is a p-type impurity, on the first contact layer 100.

In the semiconductor device 4 having such a second conductivity type (p-type) channel layer (301), the potential barrier between the first electrode 110 and the second electrode 210 can be higher than that of the semiconductor device 1 including the i-type (i.e., undoped) channel layer 300 shown in FIG. 1. Therefore, in the semiconductor device 4 according to this embodiment, a leakage current occurring between the first electrode 110 and the second electrode 210 can be inhibited, compared to the semiconductor device 1 shown in FIG. 1.

### «5. Fifth embodiment»

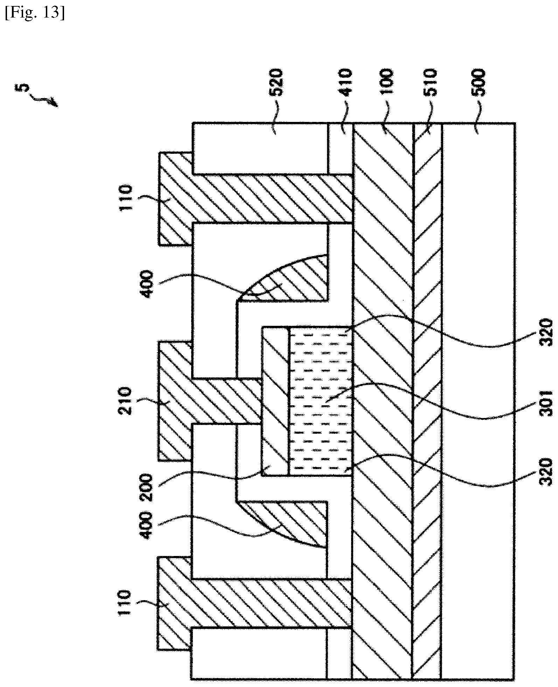

Next, a semiconductor device 5 according to a fifth embodiment of the present disclosure will be described with reference to FIG. 13. FIG. 13 is a cross-sectional view showing a multilayer structure of the semiconductor device 5 according to this embodiment. Note that components indicated by the same reference signs as those of FIG. 1, FIG. 10, and FIG. 12 are substantially the same as those shown in FIG. 1, FIG. 10, and FIG. 12, and therefore, will not be described herein.

As shown in FIG. 13, in the semiconductor device 5 according to this embodiment, a gate insulating layer 410 is provided in place of the barrier layer 310, and the channel layer 301 is formed of a second conductivity type (e.g., p-type) compound semiconductor material. In other words, the semiconductor device 5 according to this embodiment is a field effect transistor which has an MIS gate, and in which an inversion layer formed at an interface of the channel layer 301 which is in contact with the gate insulating layer 410 is a channel.

In the semiconductor device 5 according to this embodiment, a two-dimensional electron gas layer which is formed by a heterojunction of compound semiconductors is not formed, and the inversion layer formed by the MIS gate operates as a channel as in a typical field effect transistor. The semiconductor device 5 can be fabricated using a fabrication process easier than that for the semiconductor device 1 shown in FIG. 1, because it is not necessary to provide the barrier layer 310 which is epitaxially grown and formed.

### «6. Sixth embodiment»

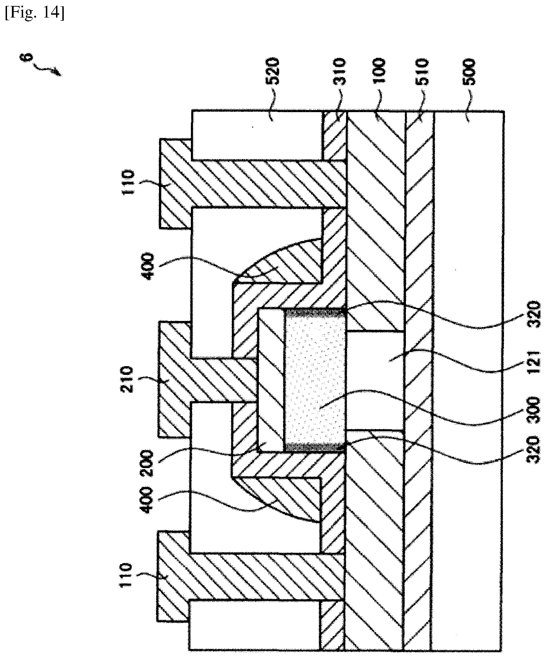

Next, a semiconductor device according to a sixth embodiment of the present disclosure will be described with reference to FIG. 14 to FIG. 16. FIG. 14 to FIG. 16 are cross-sectional views showing a first to a third structure example of the semiconductor device according to this embodiment. Note that components indicated by the same reference signs as those of FIG. 1 are substantially the same as those shown in FIG. 1, and therefore, will not be described herein.

In the semiconductor device according to this embodiment, a capacitance reduction region is provided in the first contact layer 100 below the channel layer 300 so that a parasitic capacitance (also called an "off-capacitance") during non-operation which occurs by the first contact layer 100 and the second contact layer 200, which have a low resistance, facing each other, can be reduced.

Note that the capacitance reduction region is provided in a region smaller than a region where the channel layer 300 is provided in planar view. This is because when the capacitance reduction region is formed in a region having at least the same size as that of the region where the channel layer 300 is provided in planar view, it is difficult to electrically couple the two-dimensional electron gas layer 320 formed on the side surface of the channel layer 300 to the first contact layer 100.

A specific configuration of the capacitance reduction region included in the semiconductor device according to this embodiment will now be specifically described in greater detail by illustrating the first to third structure examples.

### <6.1. First structure example>

Firstly, the first structure example will be described with reference to FIG. 14. As shown in FIG. 14, in the semiconductor device 6 according to the first structure example, a low permittivity region 121 having a permittivity lower than that of the first contact layer 100 is provided as a capacitance reduction region in the first contact layer 100 below the channel layer 300.

The low permittivity region 121 is formed of a material having a permittivity lower than that of the first contact layer 100. For example, the low permittivity region 121 may be formed of an insulating material or a cavity. Specifically, the low permittivity region 121 may be formed by removing all or a portion of the first contact layer 100 in the corresponding region using etching or the like, and then forming the channel layer 300 on that region. Alternatively, the low permittivity region 121 may be formed by burying an insulating material such as SiO₂ or the like in a region where the first contact layer 100 has been removed by etching or the like. Still alternatively, the low permittivity region 121 may be formed by etching all or a portion of the first contact layer 100 in the corresponding region from the back surface. In such a case, in addition to the first contact layer 100, a portion of the channel layer 300 may also be removed by etching from the back surface. According to the first structure example, the off-capacitance formed by the first contact layer 100 and the second contact layer 200 facing each other can be reduced.

In particular, when all the first contact layer 100 below the channel layer 300 is removed to form a cavity, a parasitic capacitance can be reduced (or alternatively, prevented) from occurring between the first contact layer 100 and the second contact layer 200.

### <6.2. Second structure example>

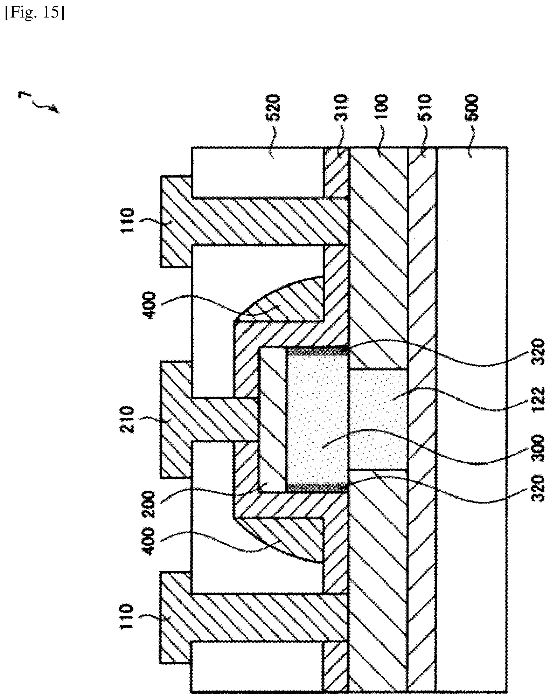

Next, the second structure example will be described with reference to FIG. 15. As shown in FIG. 15, in a semiconductor device 7 according to the second structure example, a low carrier region 122 having a carrier density lower than that of the first contact layer 100 is provided as a capacitance reduction region in the first contact layer 100 below the channel layer 300.

The low carrier region 122 is configured to have an impurity concentration lower than that of the first contact layer 100. For example, the low carrier region 122 may be a layer formed of the same compound semiconductor material as that of the first contact layer 100 that is doped with an n-type impurity (Si, etc.) at a concentration lower than that of the first contact layer 100. Alternatively, the low carrier region 122 may be a layer the resistance of which is increased by doping the first contact layer 100 with a p-type impurity (Mg, etc.).

Specifically, the low carrier region 122 may be formed by removing all or a portion of the first contact layer 100 in the corresponding region using etching or the like, and regrowing a compound semiconductor at a concentration of an n-type impurity (Si, etc.) lower than that of the first contact layer 100. Alternatively, the low carrier region 122 may be formed by additionally doping the first contact layer 100 excluding the low carrier region 122 with an n-type impurity (Si, etc.) by ion injection or the like. Still alternatively, the low carrier region 122 may be formed by doping the low carrier region 122 with a p-type impurity (Mg, etc.) by ion injection or the like, and thereby increasing the resistance of the low carrier region 122. According to the second structure example, an off-capacitance formed by the first contact layer 100 and the second contact layer 200 facing each other can be reduced.

### <6.3. Third structure example>

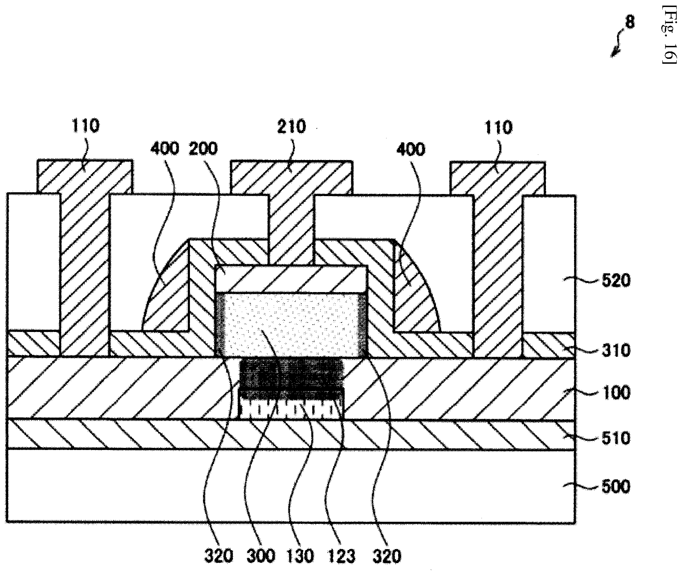

Next, the third structure example will be described with reference to FIG. 16. As shown in FIG. 16, in a semiconductor device 8 according to the third structure example, a depletion layer 123 is provided as a capacitance reduction region in the first contact layer 100 below the channel layer 300.

The depletion layer 123 is formed by a second conductivity type (e.g., p-type) depleted region 130 which is provided in the first contact layer 100. The depleted region 130 is obtained by, for example, doping the same compound semiconductor material as that of the first contact layer 100 with a p-type impurity (Mg, etc.). Specifically, the depleted region 130 may be formed by doping the corresponding region of the first contact layer 100 with a p-type impurity (Mg, etc.) by ion injection or the like.

Here, by providing the depleted region 130, the depletion layer 123 in which carriers are depleted by a p-n junction is formed below the channel layer 300. Note that the depletion layer 123 is formed, extending on both the first contact layer 100 and depleted region 130. In the depletion layer 123, the carrier density is reduced. Therefore, according to the third structure example, an off-capacitance formed by the first contact layer 100 and the second contact layer 200 facing each other can be reduced, as in the second structure example. Note that the depleted region 130 may be floating, although a bias voltage more negative than that of the second electrode 210 may be applied to the depleted region 130 by being in contact with a region outside the device region 600.

### «7. Conclusion»

As described in detail, in a semiconductor device according to one embodiment of the present disclosure, the thickness of the channel layer 300 is the distance between the source electrode and the drain electrode, and therefore, the distance between the source electrode and the drain electrode can be reduced without using state-of-the-art fabrication equipment. Therefore, in the semiconductor device according to one embodiment of the present disclosure, the channel resistance and the on-resistance can be reduced.

Also, in a semiconductor device according to one embodiment of the present disclosure, the thickness of the channel layer 300 is the gate length, and therefore, the gate length can be reduced without using state-of-the-art fabrication equipment. Therefore, the semiconductor device can operate at higher speed.

Moreover, in a semiconductor device according to one embodiment of the present disclosure, the side surface of the channel layer 300 formed in an island shape serves as a channel, and therefore, the current density can be increased. As a result, the size of the semiconductor device according to one embodiment of the present disclosure can be reduced, compared to field effect transistors having other structures.

A semiconductor device according to one embodiment of the present disclosure can be applied to electronic parts such as, for example, a radio frequency (RF) module, a power conversion module which uses a high voltage, and the like. Also, a semiconductor device according to one embodiment of the present disclosure can improve the performance of electronic apparatuses including the above electronic parts such as an alternating current (AC) adaptor, power conditioner, smartphone, mobile telephone, and the like.

It should be understood by those skilled in the art that various modifications, combinations, sub-combinations and alterations may occur depending on design requirements and other factors insofar as they are within the scope of the appended claims.

Further, the effects described in this specification are merely illustrative or exemplified effects, and are not limitative. That is, with or in the place of the above effects, the technology according to the present disclosure may achieve other effects that are clear to those skilled in the art based on the description of this specification.

### Reference Signs List

1 semiconductor device
100 first contact layer
110 first electrode
200 second contact layer
210 second electrode
300 channel layer
310 barrier layer
320 two-dimensional electron gas layer
400 gate electrode
500 substrate
510 buffer layer
520 insulating layer

## Claims

1. A semiconductor device (3) comprising:
a substrate (500);
a first contact layer (100) on the substrate (500);
a channel layer (300) on the first contact layer (100), the channel layer including a two-dimensional electron gas layer (320) on side-walls of the channel (300) in a direction perpendicular to the substrate;
a second contact layer (200) on the channel layer (300);
a barrier layer (310) on the first contact layer (100), on the second contact layer, and on the side walls of the channel layer (300);
a gate electrode (400) on at least one side surface of the barrier layer (310);
a first electrode (110) on the first contact layer (100);
a second electrode (210) on the second contact layer (200),
a semiconductor layer (420) between the gate electrode (400) and the barrier layer (310), wherein the first contact layer (100) and the second contact layer (200) are of a first conductivity type and the semiconductor layer is of a second conductivity type, wherein the semiconductor layer (420) forms a second conductivity type gate.

2. The semiconductor device (3) according to claim 1,
wherein a C-axis direction of a crystal of the channel layer is substantially perpendicular to a side surface of the channel layer (300), and/or
wherein the first electrode (110) is disposed around at least three sides of the channel layer (300) in the planar view.

3. The semiconductor device (3) according to claim 1, further comprising: an insulating layer (520) on the gate electrode (400) and the semiconductor layer (310).

4. The semiconductor device (3) according to claim 1, wherein the channel layer (300) is a semiconductor layer.

5. The semiconductor device (3) according to claim 1, wherein the gate electrode (400) and the second electrode (210) are between first and second portions of the first electrode (110).

6. The semiconductor device (3) according to claim 5,
wherein the at least one side surface of the barrier layer (310) includes a first side surface and a second side surface, and
wherein the gate electrode (400) includes a first portion on the first side surface and a second portion on the second side surface.

7. The semiconductor device (3) according to claim 6, wherein the second electrode (210) is between the first and second portions of the gate electrode (400).

8. An electronic part comprising:
a semiconductor device according to claim 1

9. An electronic apparatus comprising:
a semiconductor device according to claim 1.

10. A method for fabricating a semiconductor device (3), comprising:
forming a first contact layer (100) of a first conductivity type on a substrate (500);
forming a channel layer (300) on the first contact layer (100);
forming, in side-walls of the channel layer, a two-dimensional electron gas layer (320)
forming a second contact layer (200) of the first conductivity type on the first contact layer (100) and the channel layer (300);
etching the channel layer (300) and the second contact layer (200) to expose a portion of the first contact layer (100);
forming a barrier layer (310) on the portion of the first contact layer (100) and the etched second contact layer (200) and on the side-walls of the channel layer; wherein a 2DEG is formed in the channel layer (300) in the vicinity of an interface of the channel layer (300) with the barrier layer (310);
forming a gate electrode (400) on at least one side surface of the barrier layer (310);
forming a first electrode (110) and a second electrode (210) on the first contact layer (100) and the second contact layer (200), respectively; and
forming a semiconductor layer between the gate electrode (400) and the barrier layer (310), wherein the first contact layer (100) and the second contact layer (200) are of a first conductivity type and the semiconductor layer is of a second conductivity type, wherein the semiconductor layer (420) forms a second conductivity type gate.

## Patentansprüche

1. Halbleitervorrichtung (3), die Folgendes umfasst:
ein Substrat (500);
eine erste Kontaktschicht (100) auf dem Substrat (500);
eine Kanalschicht (300) auf der ersten Kontaktschicht (100), wobei die Kanalschicht eine zweidimensionale Elektronengasschicht (320) auf den Seitenwänden des Kanals (300) in einer Richtung senkrecht zu dem Substrat enthält;
eine zweite Kontaktschicht (200) auf der Kanalschicht (300) ;
eine Sperrschicht (310) auf der ersten Kontaktschicht (100), auf der zweiten Kontaktschicht und auf den Seitenwänden der Kanalschicht (300);
eine Gate-Elektrode (400) auf wenigstens einer Seitenfläche der Sperrschicht (310);
eine erste Elektrode (110) auf der ersten Kontaktschicht (100) ;
eine zweite Elektrode (210) auf der zweiten Kontaktschicht (200);
eine Halbleiterschicht (420) zwischen der Gate-Elektrode (400) und der Sperrschicht (310), wobei die erste Kontaktschicht (100) und die zweite Kontaktschicht (200) von einem ersten Leitfähigkeitstyp sind und die Halbleiterschicht von einem zweiten Leitfähigkeitstyp ist, wobei die Halbleiterschicht (420) ein Gate vom zweiten Leitfähigkeitstyp bildet.

2. Halbleitervorrichtung (3) nach Anspruch 1,
wobei eine C-Achsenrichtung eines Kristalls der Kanalschicht im Wesentlichen senkrecht zu einer Seitenfläche der Kanalschicht (300) ist, und/oder wobei die erste Elektrode (110) in der planaren Ansicht um wenigstens drei Seiten der Kanalschicht (300) angeordnet ist.

3. Halbleitervorrichtung (3) nach Anspruch 1, die ferner Folgendes umfasst:
eine Isolierschicht (520) auf der Gate-Elektrode (400) und der Halbleiterschicht (310).

4. Halbleitervorrichtung (3) nach Anspruch 1,
wobei die Kanalschicht (300) eine Halbleiterschicht ist.

5. Halbleitervorrichtung (3) nach Anspruch 1,
wobei die Gate-Elektrode (400) und die zweite Elektrode (210) sich zwischen einem ersten und einem zweiten Abschnitt der ersten Elektrode (110) befinden.

6. Halbleitervorrichtung (3) nach Anspruch 5,
wobei die wenigstens eine Seitenfläche der Sperrschicht (310) eine erste Seitenfläche und eine zweite Seitenfläche aufweist und
wobei die Gate-Elektrode (400) einen ersten Abschnitt auf der ersten Seitenfläche und einen zweiten Abschnitt auf der zweiten Seitenfläche aufweist.

7. Halbleitervorrichtung (3) nach Anspruch 6,
wobei sich die zweite Elektrode (210) zwischen dem ersten und dem zweiten Abschnitt der Gate-Elektrode (400) befindet.

8. Elektronisches Bauteil, das Folgendes umfasst:
eine Halbleitervorrichtung nach Anspruch 1.

9. Elektronische Einrichtung, die Folgendes umfasst:
eine Halbleitervorrichtung nach Anspruch 1.

10. Verfahren zur Herstellung einer Halbleitervorrichtung (3), das Folgendes umfasst:
Bilden einer ersten Kontaktschicht (100) eines ersten Leitfähigkeitstyps auf einem Substrat (500);
Bilden einer Kanalschicht (300) auf der ersten Kontaktschicht (100);
Bilden einer zweidimensionalen Elektronengasschicht (320) in Seitenwänden der Kanalschicht;
Bilden einer zweiten Kontaktschicht (200) des ersten Leitfähigkeitstyps auf der ersten Kontaktschicht (100) und der Kanalschicht (300);
Ätzen der Kanalschicht (300) und der zweiten Kontaktschicht (200), um einen Abschnitt der ersten Kontaktschicht (100) freizulegen;
Bilden einer Sperrschicht (310) auf dem Abschnitt der ersten Kontaktschicht (100) und der geätzten zweiten Kontaktschicht (200) und auf den Seitenwänden der Kanalschicht; wobei in der Kanalschicht (300) in der Nähe einer Grenzfläche der Kanalschicht (300) mit der Sperrschicht (310) ein 2DEG gebildet wird;
Bilden einer Gate-Elektrode (400) auf wenigstens einer Seitenfläche der Sperrschicht (310);
Bilden einer ersten Elektrode (110) und einer zweiten Elektrode (210) auf der ersten Kontaktschicht (100) bzw. der zweiten Kontaktschicht (200); und
Bilden einer Halbleiterschicht (420) zwischen der Gate-Elektrode (400) und der Sperrschicht (310), wobei die erste Kontaktschicht (100) und die zweite Kontaktschicht (200) von einem ersten Leitfähigkeitstyp sind und die Halbleiterschicht von einem zweiten Leitfähigkeitstyp ist, wobei die Halbleiterschicht (420) ein Gate vom zweiten Leitfähigkeitstyp bildet.

## Revendications

1. Dispositif semi-conducteur (3) comprenant :
un substrat (500) ;
une première couche de contact (100) sur le substrat (500) ;
une couche de canal (300) sur la première couche de contact (100), la couche de canal comportant une couche de gaz d'électrons bidimensionnel (320) sur des parois latérales du canal (300) dans une direction perpendiculaire au substrat ;
une deuxième couche de contact (200) sur la couche de canal (300) ;
une couche barrière (310) sur la première couche de contact (100), sur la deuxième couche de contact, et sur les parois latérales de la couche de canal (300) ;
une électrode de grille (400) sur au moins une surface latérale de la couche barrière (310) ;
une première électrode (110) sur la première couche de contact (100) ;
une deuxième électrode (210) sur la deuxième couche de contact (200) ;
une couche semi-conductrice (420) entre l'électrode de grille (400) et la couche barrière (310), dans lequel la première couche de contact (100) et la deuxième couche de contact (200) sont d'un premier type de conductivité et la couche semi-conductrice est d'un deuxième type de conductivité, dans lequel la couche semi-conductrice (420) forme une grille du deuxième type de conductivité.

2. Dispositif semi-conducteur (3) selon la revendication 1,
dans lequel une direction de l'axe C d'un cristal de la couche de canal est sensiblement perpendiculaire à une surface latérale de la couche de canal (300), et/ou
dans lequel la première électrode (110) est disposée autour d'au moins trois côtés de la couche de canal (300) dans la vue en plan.

3. Dispositif semi-conducteur (3) selon la revendication 1, comprenant en outre :
une couche isolante (520) sur l'électrode de grille (400) et la couche semi-conductrice (310).

4. Dispositif semi-conducteur (3) selon la revendication 1,
dans lequel la couche de canal (300) est une couche semi-conductrice.

5. Dispositif semi-conducteur (3) selon la revendication 1,
dans lequel l'électrode de grille (400) et la deuxième électrode (210) se situent entre des première et deuxième parties de la première électrode (110).

6. Dispositif semi-conducteur (3) selon la revendication 5,
dans lequel l'au moins une surface latérale de la couche barrière (310) comporte une première surface latérale et une deuxième surface latérale, et
dans lequel l'électrode de grille (400) comporte une première partie sur la première surface latérale et une deuxième partie sur la deuxième surface latérale.

7. Dispositif semi-conducteur (3) selon la revendication 6,
dans lequel la deuxième électrode (210) se situe entre les première et deuxième parties de l'électrode de grille (400).

8. Pièce électronique comprenant :
un dispositif semi-conducteur selon la revendication 1.

9. Appareil électronique comprenant :
un dispositif semi-conducteur selon la revendication 1.

10. Procédé destiné à fabriquer un dispositif semi-conducteur (3), comprenant :
la formation d'une première couche de contact (100) d'un premier type de conductivité sur un substrat (500) ;
la formation d'une couche de canal (300) sur la première couche de contact (100) ;
la formation, dans des parois latérales de la couche de canal, d'une couche de gaz d'électrons bidimensionnel (320) ;
la formation d'une deuxième couche de contact (200) du premier type de conductivité sur la première couche de contact (100) et la couche de canal (300) ;
la gravure de la couche de canal (300) et de la deuxième couche de contact (200) pour exposer une partie de la première couche de contact (100) ;
la formation d'une couche barrière (310) sur la partie de la première couche de contact (100) et la deuxième couche de contact gravée (200) et sur les parois latérales de la couche de canal ; un 2DEG étant formé dans la couche de canal (300) à proximité d'une interface de la couche de canal (300) avec la couche barrière (310) ;
la formation d'une électrode de grille (400) sur au moins une surface latérale de la couche barrière (310) ;
la formation d'une première électrode (110) et d'une deuxième électrode (210) sur la première couche de contact (100) et la deuxième couche de contact (200), respectivement ; et
la formation d'une couche semi-conductrice entre l'électrode de grille (400) et la couche barrière (310), dans lequel la première couche de contact (100) et la deuxième couche de contact (200) sont d'un premier type de conductivité et la couche semi-conductrice est d'un deuxième type de conductivité, dans lequel la couche semi-conductrice (420) forme une grille du deuxième type de conductivité.
